# EUROPEAN PATENT APPLICATION

(11) **EP 4 704 339 A1**
(43) Date of publication of application: **04.03.2026**
(21) Application number: 23935379.0
(22) Date of filing: 28.04.2023
(51) Int. Cl.: H03F 3/68, H03F 1/42, H03F 3/60

(54) **BASEBAND AMPLIFIER**

(71) Applicant: NTT, Inc., Tokyo 100-8116 (JP)
(72) Inventor: JO, Teruo, Musashino-shi, Tokyo 180-8585 (JP); NAGATANI, Munehiko, Musashino-shi, Tokyo 180-8585 (JP); TAKAHASHI, Hiroyuki, Musashino-shi, Tokyo 180-8585 (JP); ABDO, Ibrahim, Musashino-shi, Tokyo 180-8585 (JP)
(74) Representative: Samson & Partner Patentanwälte mbB
(86) International application number: PCT/JP2023/016873
(87) International publication number: WO 2024/224603

(57) **Abstract**

A baseband amplifier includes: a distributed amplifier (10); an RF amplifier (11) that has a higher frequency transmission characteristic than the distributed amplifier (10); a demultiplexer (12) that outputs, to the distributed amplifier (10), a signal that includes at least a signal component of equal to or less than a high-frequency-side cutoff frequency of the distributed amplifier (10) in an input signal and outputs, to the RF amplifier (11), a signal that includes at least a signal component of equal to or greater than a low-frequency-side cutoff frequency of the RF amplifier (11) in the input signal; and a multiplexer (13) that multiplexes a signal amplified by the distributed amplifier (10) and a signal amplified by the RF amplifier (12).

## Description

### Technical Field

The present invention relates to a baseband amplifier.

### Background Art

Baseband amplifiers are components that are essential for various applications such as optical communications and measuring instruments. In recent years, wider bands have been required by baseband amplifiers with increases in communication capacities and speeds of measuring instruments. As a configuration that realizes a broadband baseband amplifier, a distribution-type baseband amplifier as in Fig. 23 has been proposed in the related art (Non Patent Literature 1).

The distribution-type baseband amplifier includes an input transmission line CPW 10 having an input end connected to an input terminal 1, an output transmission line CPW 20 having a terminal connected to an output terminal 2, an input termination resistor R1 having one end connected to a terminal of the input transmission line CPW 10 and the other end connected to ground, an output termination resistor R2 having one end connected to an input end of the output transmission line CPW 20 and the other end connected to the ground, and a plurality of unit cells 3 disposed along the input transmission line CPW 10 and the output transmission line CPW 20, having input terminals connected to the input transmission line CPW 10 and output terminals connected to the output transmission line CPW 20.

In the distribution-type baseband amplifier, the characteristic impedance of the input transmission line CPW 10 is designed to be 50 Ω, for example, in a state where the parasitic capacitance of transistors constituting the unit cells 3 is incorporated in order to establish connection to an external device. In addition, the characteristic impedance of the output transmission line CPW 20 is designed to be 50 Ω, for example, in a state where the parasitic capacitance of the transistor is incorporated. Hereinafter, transmission lines including the parasitic capacitance of the transistors will be referred to as pseudo transmission lines in order to distinguish them from ordinary transmission lines. Furthermore, it is possible to amplify a broadband baseband signal including a signal component from a DC by matching phase speeds of the pseudo transmission line of an input and the pseudo transmission line of an output.

However, the band that can be realized by the distribution-type baseband amplifier in the related art is limited by a cutoff frequency of the pseudo transmission lines. Specifically, the band of the distribution-type baseband amplifier is about 1/2 of the maximum oscillation frequency fmax of the transistors constituting the unit cells 3. Therefore, the distribution-type baseband amplifier in the related art has a problem that it is difficult to achieve an increase in band significantly exceeding fmax/2.

### Citation List

### Non Patent Literature

Non Patent Literature 1: T.Jyo et al.,"A 241-GHz-Bandwidth Distributed Amplifier with 10-dBm P1dB in 0.25-µm InP DHBT Technology",2019 IEEE MTT-S International Microwave Symposium (IMS),Boston,MA,USA,2019,pp.1430-1433,doi:10.1109/MWSYM.2019.8700975

### Summary of Invention

### Technical Problem

The present invention was made in order to solve the above problem, and an object thereof is to provide a baseband amplifier with a broader band than before.

### Solution to Problem

A baseband amplifier according to the present invention includes: a distributed amplifier; an RF amplifier configured to have a higher frequency transmission characteristic than the distributed amplifier; a demultiplexer configured to output, to the distributed amplifier, a signal that includes at least a signal component of equal to or less than a high-frequency-side cutoff frequency of the distributed amplifier in an input signal and output, to the RF amplifier, a signal that includes at least a signal component of equal to or greater than a low-frequency-side cutoff frequency of the RF amplifier in the input signal; and a multiplexer configured to multiplex a signal amplified by the distributed amplifier and a signal amplified by the RF amplifier.

### Advantageous Effects of Invention

According to the present invention, it is possible to broaden the band of the baseband amplifier to a band significantly exceeding 1/2 of the maximum oscillation frequency of the transistor configuring each of the unit cells of the distributed amplifier and the RF amplifier by providing the RF amplifier, the demultiplexer, and the multiplexer.

### Brief Description of Drawings

Fig. 1 is a block diagram illustrating a configuration of a baseband amplifier according to a first embodiment of the present invention.
Fig. 2A is a diagram illustrating a band of an input signal according to the first embodiment of the present invention.
Fig. 2B is a diagram illustrating a band of an output signal of a demultiplexer according to the first embodiment of the present invention.
Fig. 2C is a diagram illustrating a band of an output signal of a demultiplexer according to the first embodiment of the present invention.
Fig. 2D is a diagram illustrating frequency characteristics of a distributed amplifier according to the first embodiment of the present invention.
Fig. 2E is a diagram illustrating frequency characteristics of an RF amplifier according to the first embodiment of the present invention.
Fig. 3A is a diagram illustrating a band of an output signal of the distributed amplifier according to the first embodiment of the present invention.
Fig. 3B is a diagram illustrating a band of an output signal of the RF amplifier according to the first embodiment of the present invention.
Fig. 3C is a diagram illustrating a band of an output signal of a multiplexer according to the first embodiment of the present invention.
Fig. 4 is a block diagram illustrating a configuration of a baseband amplifier according to a second embodiment of the present invention.
Fig. 5 is a circuit diagram illustrating a configuration of each unit cell of a distributed amplifier according to the second embodiment of the present invention.
Fig. 6 is a diagram illustrating a simulation result of transmission characteristics of the distributed amplifier according to the second embodiment of the present invention.
Fig. 7 is a block diagram illustrating a configuration of an RF amplifier according to the second embodiment of the present invention.
Fig. 8 is a circuit diagram illustrating a configuration of each unit cell of the RF amplifier according to the second embodiment of the present invention.
Fig. 9 is a diagram illustrating a simulation result of transmission characteristics of the RF amplifier according to the second embodiment of the present invention.
Fig. 10 is a diagram illustrating a simulation result of transmission characteristics of the baseband amplifier according to the second embodiment of the present invention.
Fig. 11 is a block diagram illustrating a configuration of a baseband amplifier according to a third embodiment of the present invention.
Fig. 12 is a block diagram illustrating another configuration of the baseband amplifier according to the third embodiment of the present invention.
Fig. 13 is a block diagram illustrating another configuration of the baseband amplifier according to the third embodiment of the present invention.
Fig. 14 is a block diagram illustrating a configuration of a baseband amplifier according to a fourth embodiment of the present invention.
Fig. 15 is a block diagram illustrating another configuration of the baseband amplifier according to the fourth embodiment of the present invention.
Fig. 16 is a block diagram illustrating another configuration of the baseband amplifier according to the fourth embodiment of the present invention.
Fig. 17 is a block diagram illustrating another configuration of the baseband amplifier according to the fourth embodiment of the present invention.
Fig. 18 is a block diagram illustrating a configuration of a baseband amplifier according to a fifth embodiment of the present invention.
Fig. 19A is a diagram illustrating frequency characteristics of a gain and a return loss of a distributed amplifier according to the fifth embodiment of the present invention.
Fig. 19B is a diagram illustrating frequency characteristics of a gain and a return loss of an RF amplifier according to the fifth embodiment of the present invention.
Fig. 20 is a block diagram illustrating a configuration of a baseband amplifier according to a sixth embodiment of the present invention.
Fig. 21A is a diagram illustrating frequency characteristics of an RF amplifier according to the sixth embodiment of the present invention.
Fig. 21B is a diagram illustrating frequency characteristics of the RF amplifier according to the sixth embodiment of the present invention.
Fig. 21C is a diagram illustrating a band of an output signal of the RF amplifier according to the sixth embodiment of the present invention.
Fig. 21D is a diagram illustrating a band of an output signal of the RF amplifier according to the sixth embodiment of the present invention.
Fig. 21E is a diagram illustrating a band of an output signal of a multiplexer according to the sixth embodiment of the present invention.
Fig. 22 is a diagram illustrating a band of an output signal of the multiplexer according to the sixth embodiment of the present invention.
Fig. 23 is a block diagram illustrating a configuration of a distribution-type baseband amplifier in the related art.

### Description of Embodiments

### [First Embodiment]

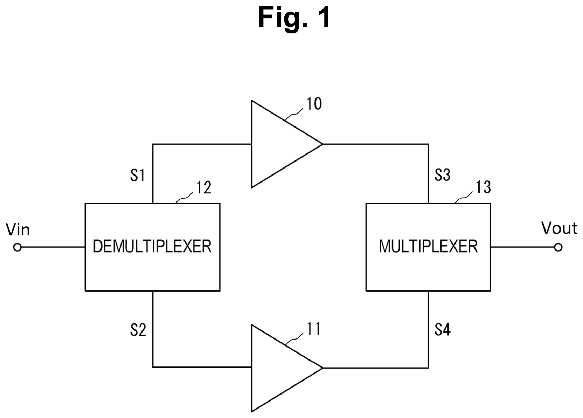

Hereinafter, an embodiment of the present invention will be described with reference to the drawings. Fig. 1 is a block diagram illustrating a configuration of a baseband amplifier according to a first embodiment of the present invention. In the following description, the baseband amplifier will be abbreviated as a BB amplifier. The BB amplifier according to the present embodiment includes: a distributed amplifier 10, a radio frequency (RF) amplifier 11 that has a higher frequency transmission characteristic than the distributed amplifier 10; a demultiplexer 12 that outputs, to the distributed amplifier 10, a signal that includes at least a signal component of equal to or less than a high-frequency-side cutoff frequency of the distributed amplifier 10 in an input signal Vin and outputs, to the RF amplifier 11, a signal that includes at least a signal component of equal to or greater than a low-frequency-side cutoff frequency of the RF amplifier 11 in the input signal Vin; and a multiplexer 13 that multiplexes a signal amplified by the distributed amplifier 10 and a signal amplified by the RF amplifier 11.

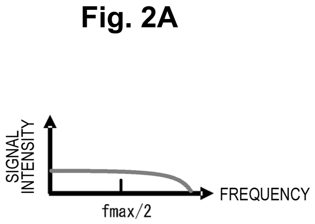

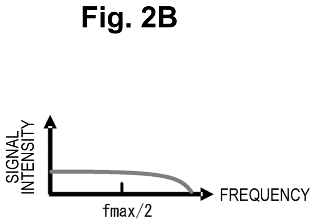

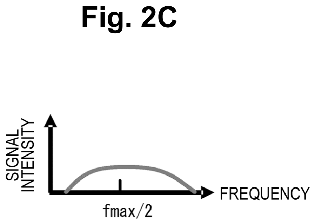

The demultiplexer 12 outputs a broadband input signal Vin as illustrated in Fig. 2A by splitting the signal into two signals, namely a signal S1 in a band as illustrated in Fig. 2B and a signal S2 in a band as illustrated in Fig. 2C. It is only necessary for the signal S1 to be a signal that includes at least a signal component of equal to or less than the high-frequency-side cutoff frequency of the distributed amplifier 10 and may include a signal component of equal to or greater than the high-frequency-side cutoff frequency. It is only necessary for the signal S2 to be a signal that includes at least a signal component of equal to or greater than the low-frequency-side cutoff frequency of the RF amplifier 11 and may include a signal component of equal to or less than the low-frequency-side cutoff frequency.

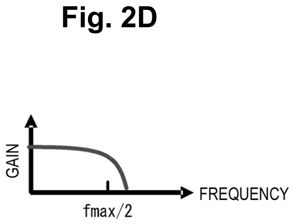

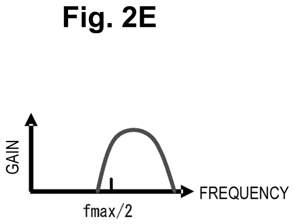

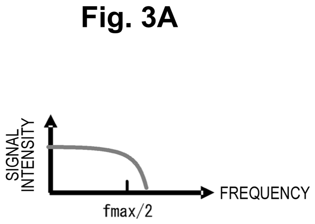

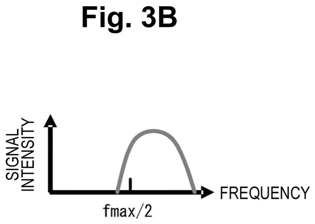

Frequency characteristics of the distributed amplifier 10 are shown in Fig. 2D, while frequency characteristics of the RF amplifier 11 are shown in Fig. 2E. The distributed amplifier 10 amplifies the signal S1 and outputs a signal S3 in a band as in Fig. 3A. The RF amplifier 11 amplifies the signal S2 and outputs a signal S4 in a band as in Fig. 3B. Configurations of the distributed amplifier 10 and the RF amplifier 11 will be described later.

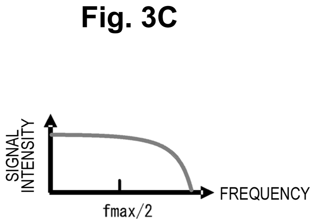

The multiplexer 13 multiplexes the signal S3 output from the distributed amplifier 10 and the signal S4 output from the RF amplifier 11. The band of an output signal Vout of the multiplexer 13 is shown in Fig. 3C.

With the configuration as described above, it is possible to broaden the band of the BB amplifier to a band significantly exceeding 1/2 of fmax of the transistors configuring the unit cells of the distributed amplifier 10 in the present embodiment.

### [Second Embodiment]

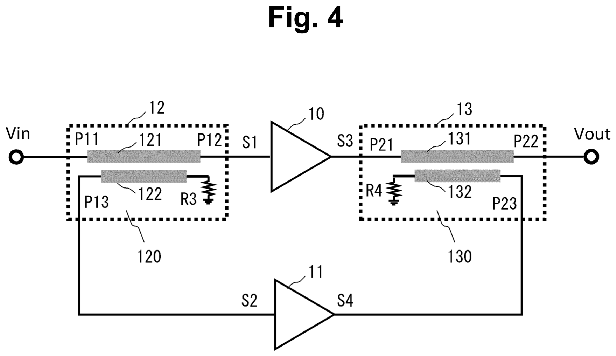

In a second embodiment of the present invention, a specific example of the first embodiment will be described. Fig. 4 is a block diagram illustrating a configuration of a BB amplifier according to the present embodiment. In the present embodiment, a directional coupler is used for each of a demultiplexer 12 and a multiplexer 13. The reason that the directional coupler is used is because demultiplexing and multiplexing of a broadband baseband signal including a signal component from a DC is facilitated. Also, in order to keep flatness of a gain in the entire BB amplifier, it is necessary to adjust intensities of signals S2 and S4 on the side of an RF amplifier 11. If the directional couplers are used as the demultiplexer 12 and the multiplexer 13, then the intensities of the signals can be easily adjusted depending on degrees of coupling of the directional couplers.

The directional coupler 120 configuring the demultiplexer 12 includes a transmission line 121 disposed between an input port P11 and a transmitted port P12, a transmission line 122 electromagnetically coupled to the transmission line 121, and a termination resistor R3 having one end connected to an end portion on the side opposite to a coupled port P13 out of two end portions of the transmission line 122 and the other end connected to the ground. In the directional coupler 120, the input port P11 is connected to an input terminal of the BB amplifier, the transmitted port P12 is connected to an input terminal of the distributed amplifier 10, and the coupled port P13 is connected to an input terminal of the RF amplifier 11.

The directional coupler 130 configuring the multiplexer 13 includes a transmission line 131 disposed between an input port P21 and a transmitted port P22, a transmission line 132 electromagnetically coupled to the transmission line 131, and a termination resistor R4 having one end connected to an end portion on the side opposite to a coupled port P23 out of two end portions of the transmission line 132 and the other end connected to the ground. In the directional coupler 130, the input port P21 is connected to an output terminal of the distributed amplifier 10, the transmitted port P22 is connected to an output terminal of the BB amplifier, and the coupled port P23 is connected to an output terminal of the RF amplifier 11.

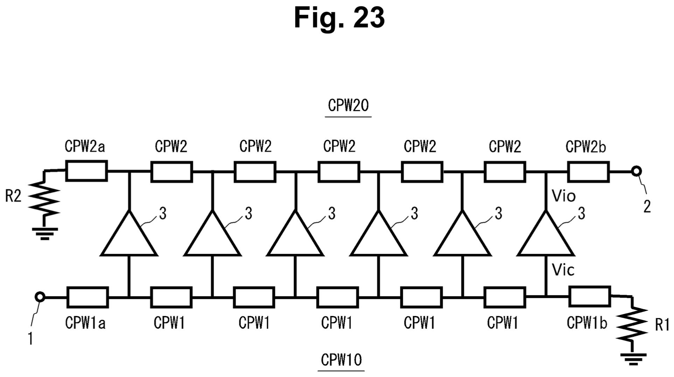

Since the overall configuration of the distributed amplifier 10 is the same as that in the related art, description will be given with reference to Fig. 23. The distributed amplifier 10 includes an input transmission line CPW 10 having an input end connected to an input terminal 1 of the distributed amplifier 10 (a first output terminal of the demultiplexer 12), an output transmission line CPW 20 having a terminal connected to an output terminal 2 of the distributed amplifier 10 (a first input terminal of the multiplexer 13), an input termination resistor R1 having one end connected to a terminal of the input transmission line CPW 10 and the other end connected to the ground, an output termination resistor R2 having one end connected to an input end of the output transmission line CPW 20 and the other end connected to the ground, and a plurality of unit cells 3 disposed along the input transmission line CPW 10 and the output transmission line CPW 20 and having input terminals connected to the input transmission line CPW 10 and output terminals connected to the output transmission line CPW 20.

The transmission line CPW 10 has a configuration in which a plurality of transmission lines CPW 1a, CPW 1, and CPW 1b are connected in series. The transmission line CPW 1 between the unit cells and the transmission line CPW 1a on the input side have different characteristic impedances. This is because in the case of the transmission line CPW 1a, it is necessary for the transmission line CPW 1a to absorb influences of the parasitic capacitances of circuits such as the demultiplexer 12 on the input side. Similarly, the transmission lines CPW 1 and CPW 1b have different characteristic impedances. This is because in the case of the transmission line CPW 1b, it is necessary for the transmission line CPW 1b to absorb influences of the parasitic capacitance of the input termination resistor R1.

The transmission line CPW 20 has a configuration in which a plurality of transmission lines CPW 2a, CPW 2, and CPW 2b are connected in series. The transmission line CPW 2 between the unit cells and the transmission line CPW 2a on the input side have different characteristic impedances. This is because in the case of the transmission line CPW 2a, it is necessary for the transmission line CPW 2a to absorb influences of the parasitic capacitance of the output termination resistor R2. Similarly, the transmission lines CPW 2 and CPW 2b have different characteristic impedances. This is because in the case of the transmission line CPW 2b, it is necessary for the transmission line CPW 2b to absorb influences of the parasitic capacitances of circuits such as the multiplexer 13 on the output side.

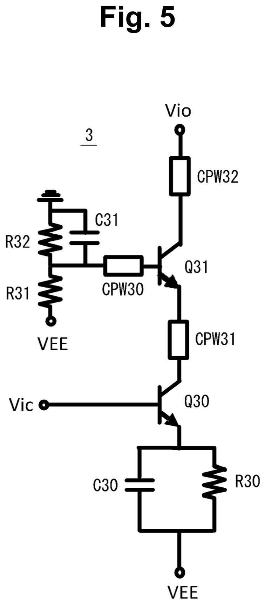

A configuration of each unit cell 3 of the distributed amplifier 10 is illustrated in Fig. 5. Each unit cell 3 includes a transistor Q30 having a base terminal connected to the transmission line CPW 10, a transistor Q31, a resistor R30 having one end connected to an emitter terminal of the transistor Q30 and the other end connected to a power source voltage VEE, a resistor R31 having one end connected to the power source voltage VEE, a resistor R32 having one end connected to the other end of the resistor R31 and the other end connected to the ground, a capacitor C30 having one end connected to the emitter terminal of the transistor Q30 and the other end connected to the power source voltage VEE, a capacitor C31 having one end connected to a connection point between the resistors R31 and R32 and the other end connected to the ground, a transmission line CPW 30 inserted between the connection point between the resistors R31 and R32 and a base terminal of the transistor Q30, a transmission line CPW 31 inserted between a collector terminal of the transistor Q30 and an emitter terminal of the transistor Q31, and a transmission line CPW 32 inserted between a collector terminal of the transistor Q31 and the transmission line CPW 20.

A loss occurring in the demultiplexer 12 and the multiplexer 13 increases as the frequency increases. In order to compensate for the loss, the configuration illustrated in Fig. 5 realizes frequency peaking characteristics such that a gain of the distributed amplifier 10 is high on the high-frequency side. In other words, the distributed amplifier 10 has a higher gain on the high-frequency side than a gain on the low-frequency side in the band.

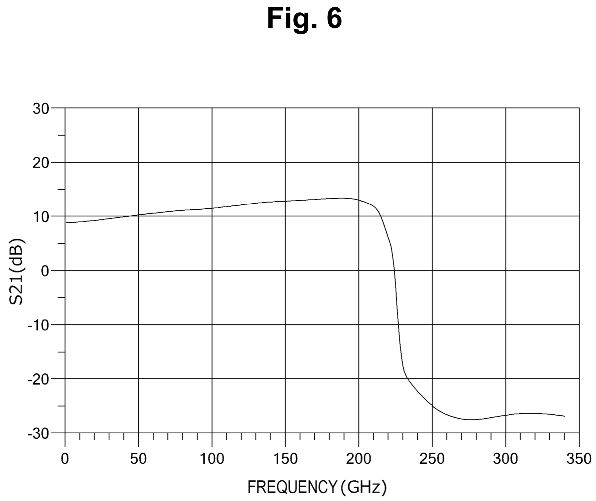

A simulation result of transmission characteristics of the distributed amplifier 10 in the present embodiment is illustrated in Fig. 6. The vertical axis in Fig. 6 is an S parameter S21 indicating the transmission characteristics of the distributed amplifier 10.

The maximum oscillation frequency fmax of the transistors Q30 and Q31 used in the simulation in Fig. 6 is about 450 GHz. Therefore, the band of the distributed amplifier 10 falls within a range of DC to 220 GHz which is 1/2 of fmax.

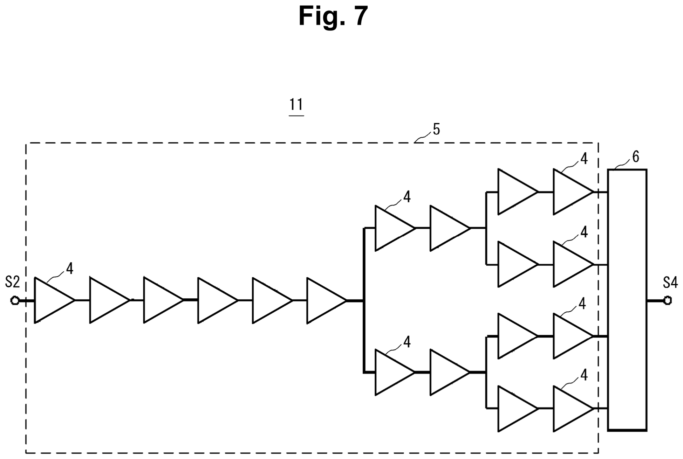

A configuration of the RF amplifier 11 in the present embodiment is illustrated in Fig. 7. The RF amplifier 11 includes a serial-parallel circuit 5 that is a combination of a circuit in which unit cells 4 that amplify signals are aligned in parallel and a circuit in which the unit cells 4 are aligned in series, and a multiplexer 6 (power combiner) that multiplexes output signals of the unit cells 4 in the final stage of the parallel alignment.

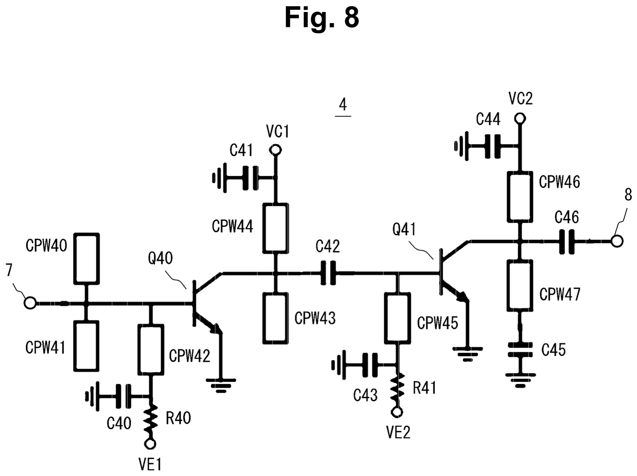

A configuration of each unit cell 4 is illustrated in Fig. 8. The unit cell 4 includes a transistor Q40 having a base terminal connected to an input terminal 7 of the unit cell 4 and an emitter terminal connected to the ground, a transistor Q41 having an emitter terminal connected to the ground, transmission lines CPW 40 and 41 each having one end connected to a base terminal of the transistor Q40 and the other end opened, a transmission line CPW 42 having one end connected to the base terminal of the transistor Q40, a transmission line CPW 43 having one end connected to a collector terminal of the transistor Q40 and the other end opened, a transmission line CPW 44 having one end connected to the collector terminal of the transistor Q40 and the other end connected to a power source voltage VC1, a transmission line CPW 45 having one end connected to a base terminal of the transistor Q41, a transmission line CPW 46 having one end connected to a collector terminal of the transistor Q41 and the other end connected to a power source voltage VC2, a transmission line CPW 47 having one end connected to the collector terminal of the transistor Q41, a resistor R40 having one end connected to the other end of the transmission line CPW 42 and the other end connected to a power source voltage VE1, a resistor R41 having one end connected to the other end of the transmission line CPW 45 and the other end connected to a power source voltage VE2, a capacitor C40 having one end connected to the other end of the transmission line CPW 42 and the other end connected to the ground, a capacitor C41 having one end connected to the other end of the transmission line CPW 44 and the other end connected to the ground, a capacitor C42 having one end connected to the collector terminal of the transistor Q40 and the other end connected to the base terminal of the transistor Q41, a capacitor C43 having one end connected to the other end of the transmission line CPW 45 and the other end connected to the ground, a capacitor C44 having one end connected to the other end of the transmission line CPW 46 and the other end connected to the ground, a capacitor C45 having one end connected to the other end of the transmission line CPW 47 and the other end connected to the ground, and a capacitor C46 having one end connected to a collector terminal of a transistor Q41 and the other end connected to an output terminal 8 of the unit cell 4.

Unlike the distributed amplifier 10, the RF amplifier 11 can perform impedance matching at a high frequency using stubs (CPW 40 to CPW 47) and the like. Therefore, the RF amplifier 11 having a gain at a frequency of equal to or greater than fmax/2 can be easily realized. However, the stub basically exhibits its effect only in the vicinity of a frequency corresponding to 1/4 wavelength. Therefore, the RF amplifier 11 tends to have a narrow band.

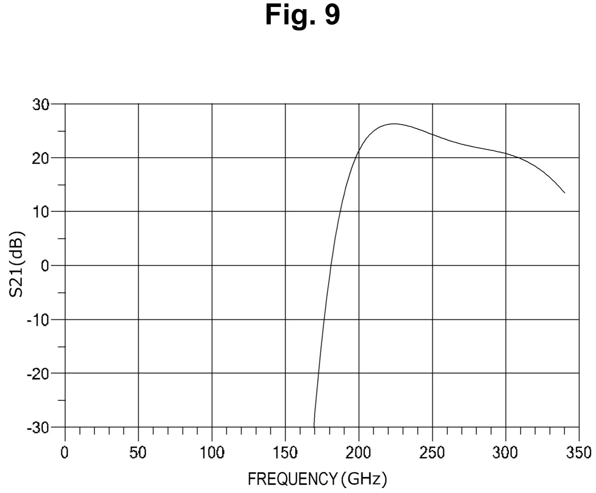

A simulation result of transmission characteristics of the RF amplifier 11 in the present embodiment is illustrated in Fig. 9. Transistors Q40 and Q41 used for the simulation in Fig. 9 are the same as the transistors Q30 and Q31 used for the simulation in Fig. 6. In order to keep flatness of a gain of the entire BB amplifier after multiplexing, the RF amplifier 11 is designed such that a gain thereof on the low-frequency side is higher than a gain on the high-frequency side.

In addition, in a case where the demultiplexer 12 and the multiplexer 13 are realized using the directional couplers, losses are caused by the directional couplers, and it is necessary to set the gain of the RF amplifier 11 to be higher than the gain of the distributed amplifier 10. In order to keep flatness of a gain of the entire BB amplifier, it is desirable that a difference between a gain in the band of the RF amplifier 11 and a gain in the band of the distributed amplifier 10 be equal to a sum of coupling losses occurring at the demultiplexer 12 and the multiplexer 13.

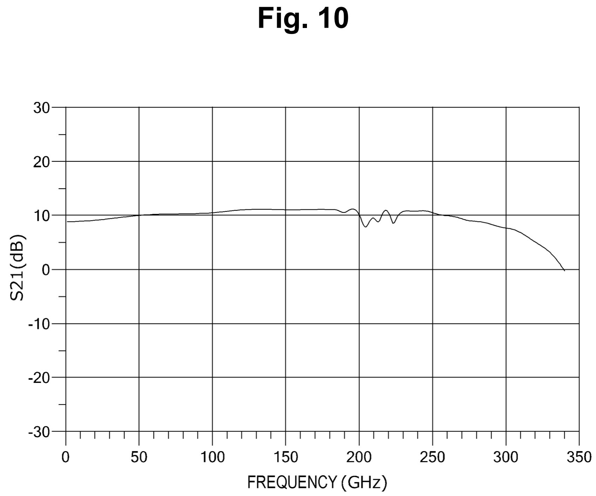

A simulation result of transmission characteristics of the BB amplifier configured using the demultiplexer 12, the multiplexer 13, the distributed amplifier 10, and the RF amplifier 11 described in the present embodiment is illustrated in Fig. 10. According to Fig. 10, the band of the BB amplifier in the present embodiment extends from DC to 320 GHz and significantly exceeds 1/2 of fmax of the transistors Q30, Q31, Q40, and Q41, and it is possible to confirm that an increase in band to equal to or greater than 100 GHz can be achieved for the distribution-type BB amplifier in the related art.

### [Third Embodiment]

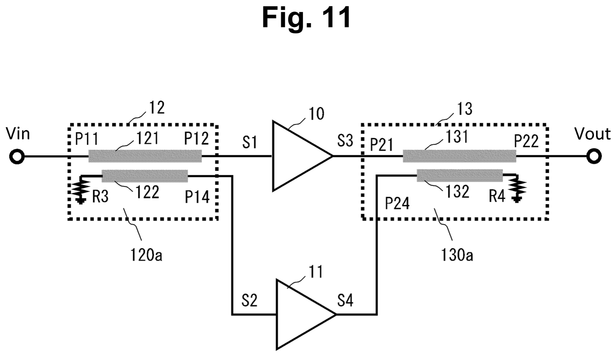

Fig. 11 is a block diagram illustrating a configuration of a BB amplifier according to a third embodiment of the present invention. In the present embodiment, isolated ports of directional couplers used as a demultiplexer 12 and a multiplexer 13 are connected to an RF amplifier 11. In other words, in a directional coupler 120a configuring the demultiplexer 12, an input port P11 is connected to an input terminal of the BB amplifier, a transmitted port P12 is connected to an input terminal of a distributed amplifier 10, and an isolated port P14 is connected to an input terminal of the RF amplifier 11. In a directional coupler 130a configuring the multiplexer 13, an input port P21 is connected to an output terminal of the distributed amplifier 10, a transmitted port P22 is connected to an output terminal of the BB amplifier, and an isolated port P24 is connected to an output terminal of the RF amplifier 11.

A degree of coupling between the demultiplexer 12 and the RF amplifier 11 and a degree of coupling between the RF amplifier 11 and the multiplexer 13 are increased by degrading isolation characteristics of the directional couplers 120a and 130a used as the demultiplexer 12 and the multiplexer 13.

With the configuration of the present embodiment, it is possible to simplify circuit layouts at a connecting portion between an input of the RF amplifier 11 and the demultiplexer 12 and a connecting portion between an output of the RF amplifier 11 and the multiplexer 13, and to improve a gain and a band of the entire BB amplifier.

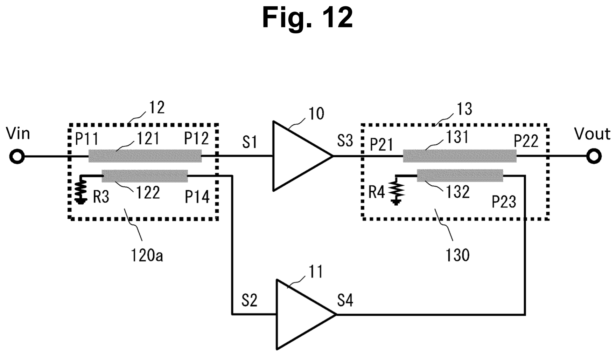

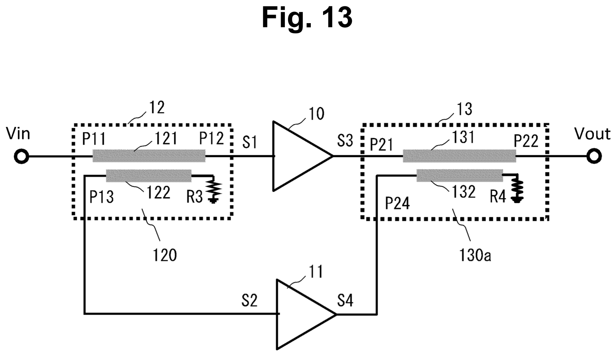

Note that as illustrated in Fig. 12, the input terminal of the RF amplifier 11 may be connected to the isolated port P14 of the directional coupler 120a and the output terminal of the RF amplifier 11 may be connected to the coupled port P23 of the directional coupler 130 similarly to Fig. 4. Also, as illustrated in Fig. 13, the input terminal of the RF amplifier 11 may be connected to the coupled port P13 of the directional coupler 120, and the output terminal of the RF amplifier 11 may be connected to the isolated port P24 of the directional coupler 130a.

### [Fourth Embodiment]

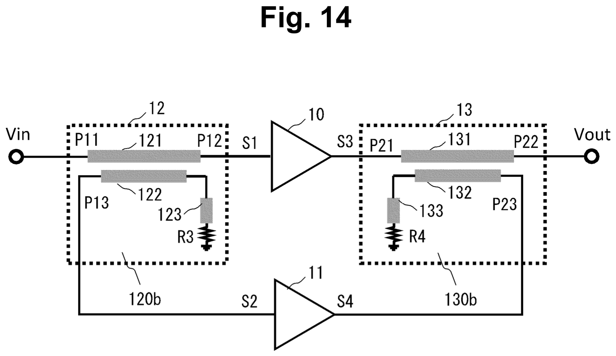

Fig. 14 is a block diagram illustrating a configuration of a BB amplifier according to a fourth embodiment of the present invention. A directional coupler 120b configuring a demultiplexer 12 includes a transmission line 121 disposed between an input port P11 and a transmitted port P12, a transmission line 122 electromagnetically coupled to the transmission line 121, a transmission line 123 having one end connected to an end portion on the side opposite to a coupled port P13 out of two end portions of the transmission line 122, and a termination resistor R3 having one end connected to the other end of the transmission line 123 and the other end connected to the ground.

A directional coupler 130b configuring a multiplexer 13 in the present embodiment includes a transmission line 131 disposed between an input port P21 and a transmitted port P22, a transmission line 132 electromagnetically coupled to the transmission line 131, a transmission line 133 having one end connected to an end portion on the side opposite to a coupled port P23 out of two end portions of the transmission line 132, and a termination resistor R4 having one end connected to the other end of the transmission line 133 and the other end connected to the ground.

In the present embodiment, the transmission lines 123 and 133 that are not involved in coupling are added between the transmission lines 122 and 132 and the termination resistors R3 and R4 in the second embodiment. It is thus possible to adjust the impedances of the ports P12 and P13 of the directional coupler 120b connected to the amplifiers 10 and 11 and to reduce reflection between the directional coupler 120b and the amplifiers 10 and 11. Similarly, it is possible to adjust impedances of the ports P21 and P23 which are ports of the directional coupler 130b connected to the amplifiers 10 and 11 and to reduce reflection between the directional coupler 130b and the amplifiers 10 and 11. As a result, it is possible to suppress ripple characteristics of the entire BB amplifier and to improve band characteristics in the present embodiment.

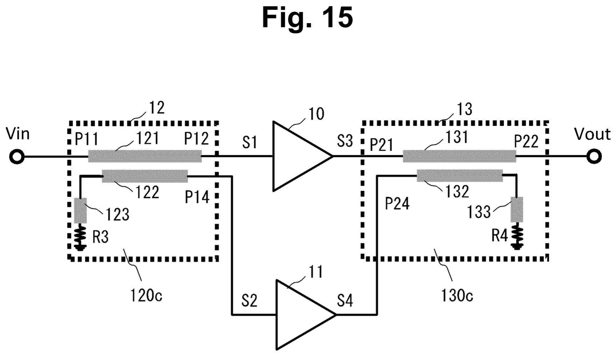

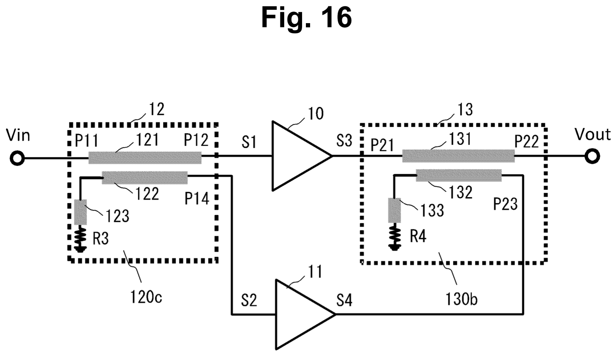

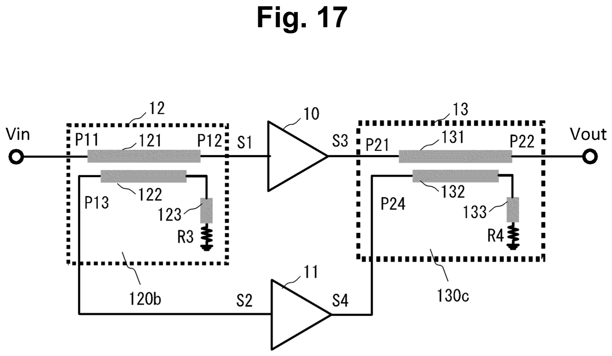

Although the present embodiment is applied to the second embodiment in the example in Fig. 14, the present embodiment may be applied to the third embodiment. A configuration in a case where the present embodiment is applied to the configuration in Fig. 11 is illustrated in Fig. 15, a configuration in a case where the present embodiment is applied to the configuration in Fig. 12 is illustrated in Fig. 16, and a configuration in a case where the present embodiment is applied to the configuration in Fig. 13 is illustrated in Fig. 17.

A directional coupler 120c includes a transmission line 121 disposed between an input port P11 and a transmitted port P12, a transmission line 122 electromagnetically coupled to the transmission line 121, a transmission line 123 having one end connected to an end portion on the side opposite to an isolated port P14 out of two end portions of the transmission line 122, and a termination resistor R3 having one end connected to the other end of the transmission line 123 and the other end connected to the ground.

A directional coupler 130c includes a transmission line 131 disposed between an input port P21 and a transmitted port P22, a transmission line 132 electromagnetically coupled to the transmission line 131, a transmission line 133 having one end connected to an end portion on the side opposite to an isolated port P24 out of two end portions of the transmission line 132, and a termination resistor R4 having one end connected to the other end of the transmission line 133 and the other end connected to the ground.

### [Fifth Embodiment]

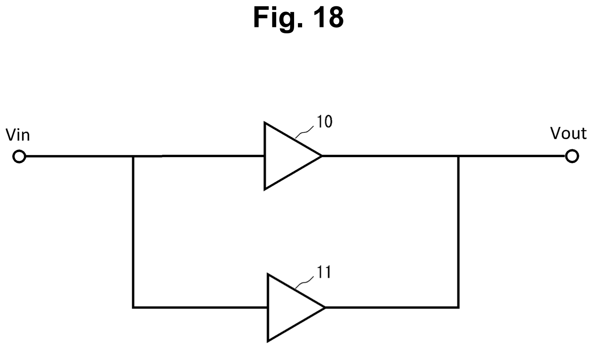

Fig. 18 is a block diagram illustrating a configuration of a BB amplifier according to a fifth embodiment of the present invention. The BB amplifier in the present embodiment is adapted such that an input terminal of a distributed amplifier 10 and an input terminal of an RF amplifier 11 are connected to each other and an output terminal of the distributed amplifier 10 and an output terminal of the RF amplifier 11 are connected to each other.

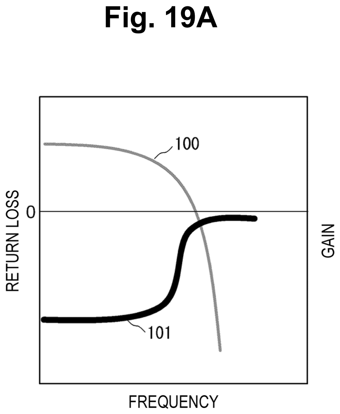

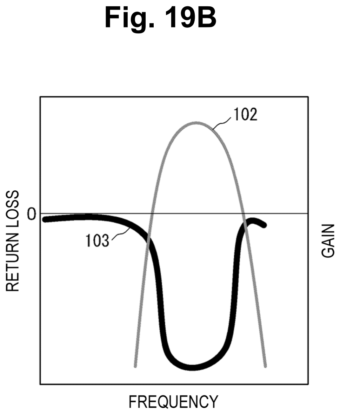

Frequency characteristics of a gain and a return loss of the distributed amplifier 10 in the present embodiment are illustrated in Fig. 19A, and frequency characteristics of a gain and a return loss of the RF amplifier 11 in the present embodiment are illustrated in Fig. 19B. In Fig. 19A, 100 denotes the gain of the distributed amplifier 10, and 101 denotes the return loss of the distributed amplifier 10. In Fig. 19B, 102 denotes the gain of the RF amplifier 11, and 103 denotes the return loss of the RF amplifier 11.

In the distributed amplifier 10 in the present embodiment, an input/output impedance outside the band is a high impedance (the return loss is near 0 dB). Similarly, the input/output impedance outside the band is a high impedance in the RF amplifier 11. Specifically, it is only necessary for each of the distributed amplifier 10 and the RF amplifier 11 to have an input/output impedance outside the band of equal to or greater than 250 Ω, for example. In a case where the input/output impedances outside the bands of the distributed amplifier 10 and the RF amplifier 11 are high impedances in this manner, it is possible to expand the band of the BB amplifier by establishing connection between the input terminals and between the output terminals of the distributed amplifier 10 and the RF amplifier 11. According to the present embodiment, it is possible to omit the demultiplexer and the multiplexer and to thereby improve the gain and the band characteristics of the entire BB amplifier with a small area.

### [Sixth Embodiment]

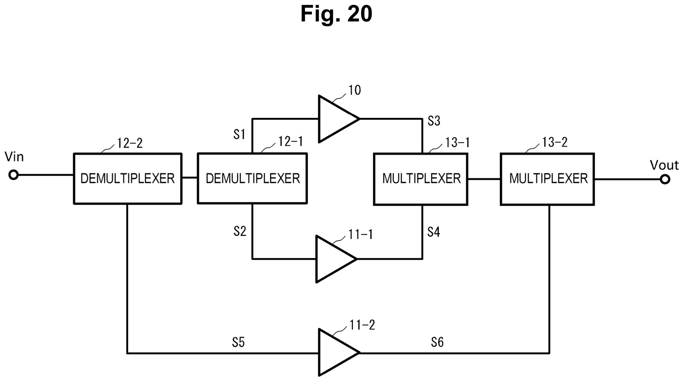

Fig. 20 is a block diagram illustrating a configuration of a BB amplifier according to a sixth embodiment of the present invention. The BB amplifier in the present embodiment includes a distributed amplifier 10, a plurality of RF amplifiers 11-1 and 11-2 having higher frequency transmission characteristics than the distributed amplifier 10, a plurality of demultiplexers 12-1 and 12-2 connected in series, and a plurality of multiplexers 13-1 and 13-2 connected in series.

The RF amplifiers 11-1 and 11-2 have different frequency transmission characteristics. The number of demultiplexers 12-1 and 12-2 provided and the number of multiplexers 13-1 and 13-2 provided are the same as the number of RF amplifiers 11-1 and 11-2.

The demultiplexer 12-1 from among the plurality of demultiplexers 12-1 and 12-2 outputs, to the distributed amplifier 10, a signal that includes at least a signal component of equal to or less than a high-frequency-side cutoff frequency of the distributed amplifier 10 in an input signal to the demultiplexer 12-1 itself and outputs, to the RF amplifier 11-1 as an output destination, a signal that includes at least a signal component of equal to or greater than a low-frequency-side cutoff frequency of the RF amplifier 11-1 in the input signal to the demultiplexer 12-1 itself.

The demultiplexer 12-2 in the previous stage of the demultiplexer 12-1 from among the plurality of demultiplexers 12-1 and 12-2 outputs, to the demultiplexer 12-1 in the subsequent stage, a signal that includes at least a signal component of equal to or less than the high-frequency-side cutoff frequency of the distributed amplifier 10 in an input signal to the demultiplexer 12-2 itself and outputs, to the RF amplifier 11-2 as an output destination that is different from that of the demultiplexer 12-1, a signal that includes at least a signal component of equal to or greater than a low-frequency-side cutoff frequency of the RF amplifier 11-2 in the input signal to the demultiplexer 12-2 itself.

The multiplexer 13-1 from among the plurality of multiplexers 13-1 and 13-2 multiplexes an output signal of the RF amplifier 11-1 that adopts the demultiplexer 12-1 to which the distributed amplifier 10 is connected as a signal input source with an output signal of the distributed amplifier 10. The multiplexer 13-2 multiplexes an output signal of the RF amplifier 11-2 that adopts the demultiplexer 12-2 in the previous stage of the demultiplexer 12-1 to which the RF amplifier 11-1 outputting a signal to the multiplexer 13-1 in the previous stage is connected as a signal input source with an output signal of the multiplexer 13-1 in the previous stage.

The band of an input signal Vin is the same as the band illustrated in Fig. 2A. The band of a signal S1 input to the distributed amplifier 10 is the same as the band illustrated in Fig. 2B. The band of signals S2 and S5 input to the RF amplifier 11-1 is the same as the band illustrated in Fig. 2C. The frequency characteristics of the distributed amplifier 10 are the same as the frequency characteristics illustrated in Fig. 2D. The band of an output signal S3 of the distributed amplifier 10 is the same as the band illustrated in Fig. 3A.

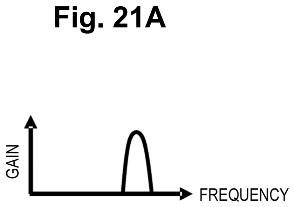

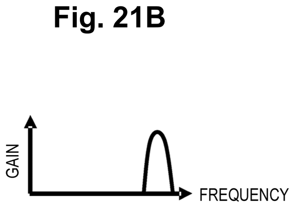

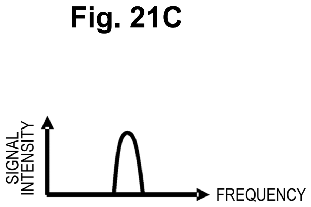

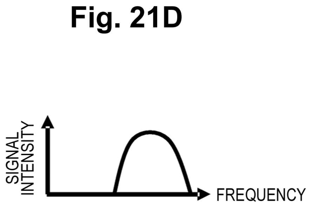

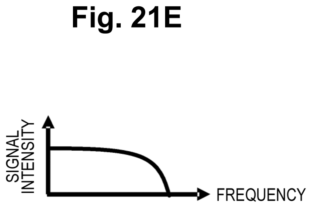

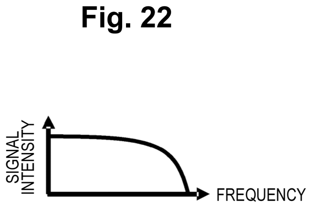

The frequency characteristics of the RF amplifier 11-1 are illustrated in Fig. 21A, while the frequency characteristics of the RF amplifier 11-2 are illustrated in Fig. 21B. The RF amplifier 11-1 amplifies the signal S2 and outputs a signal S4 in a band as in Fig. 21C. The RF amplifier 11-2 amplifies the signal S5 and outputs a signal S6 in a band as in Fig. 21D. The band of an output signal of the multiplexer 13-1 is illustrated in Fig. 21E, while the band of an output signal of the multiplexer 13-2 is illustrated in Fig. 22.

Although two RF amplifiers are provided in the present embodiment, three or more RF amplifiers in different bands may be provided.

Some or all of the embodiments described above may be described as the following supplementary notes, but are not limited to the following.

(Supplement 1) A baseband amplifier according to the present invention includes: a distributed amplifier; an RF amplifier configured to have a higher frequency transmission characteristic than the distributed amplifier; a demultiplexer configured to output, to the distributed amplifier, a signal that includes at least a signal component of equal to or less than a high-frequency-side cutoff frequency of the distributed amplifier in an input signal and output, to the RF amplifier, a signal that includes at least a signal component of equal to or greater than a low-frequency-side cutoff frequency of the RF amplifier in the input signal; and a multiplexer configured to multiplex a signal amplified by the distributed amplifier and a signal amplified by the RF amplifier.

(Supplement 2) In the baseband amplifier according to Supplement 1, each of the demultiplexer and the multiplexer includes a directional coupler, the directional coupler configuring the demultiplexer has an input port connected to an input terminal of the baseband amplifier, a transmitted port connected to an input terminal of the distributed amplifier, and a coupled port connected to an input terminal of the RF amplifier, and the directional coupler configuring the multiplexer has an input port connected to an output terminal of the distributed amplifier, a transmitted port connected to an output terminal of the baseband amplifier, and a coupled port connected to an output terminal of the RF amplifier.

(Supplement 3) In the baseband amplifier according to Supplement 1, a gain of the RF amplifier is higher than a gain of the distributed amplifier, and a difference between a gain in a band of the RF amplifier and a gain in a band of the distributed amplifier is equal to a sum of coupling losses occurring in the demultiplexer and the multiplexer.

(Supplement 4) In the baseband amplifier according to Supplement 1, in the distributed amplifier, a high-frequency-side gain is higher than a low-frequency-side gain in a band of the distributed amplifier, and in the RF amplifier, a low-frequency-side gain is higher than a high-frequency-side gain in a band of the RF amplifier.

(Supplement 5) In the baseband amplifier according to Supplement 1, each of the demultiplexer and the multiplexer includes a directional coupler, the directional coupler configuring the demultiplexer has an input port connected to an input terminal of the baseband amplifier, a transmitted port connected to an input terminal of the distributed amplifier, and an isolated port connected to an input terminal of the RF amplifier, and the directional coupler configuring the multiplexer has an input port connected to an output terminal of the distributed amplifier, a transmitted port connected to an output terminal of the baseband amplifier, and an isolated port connected to an output terminal of the RF amplifier.

(Supplement 6) In the baseband amplifier according to Supplement 1, each of the demultiplexer and the multiplexer includes a directional coupler, the directional coupler configuring the demultiplexer includes a first transmission line disposed between an input port and a transmitted port, a second transmission line configured to be electromagnetically coupled to the first transmission line, a third transmission line having one end connected to an end portion on a side opposite to a coupled port or an isolated port out of two end portions of the second transmission line, and a first termination resistor having one end connected to the other end of the third transmission line and the other end connected to ground, and the directional coupler configuring the multiplexer includes a fourth transmission line disposed between an input port and a transmitted port, a fifth transmission line configured to be electromagnetically coupled to the fourth transmission line, a sixth transmission line having one end connected to an end portion on a side opposite to a coupled port or an isolated port out of two end portions of the fifth transmission line, and a second termination resistor having one end connected to the other end of the sixth transmission line and the other end connected to the ground.

(Supplement 7) In the baseband amplifier according to Supplement 1, a plurality of the RF amplifiers are disposed to be aligned in parallel with the distributed amplifier, a plurality of the demultiplexers are disposed to be aligned in series, the number of the demultiplexers being the same as the number of the RF amplifiers, a plurality of the multiplexers are disposed to be aligned in series, the number of the multiplexers being the same as the number of the RF amplifiers, the plurality of disposed RF amplifiers have mutually different frequency transmission characteristics, a first demultiplexer from among the plurality of disposed demultiplexers outputs, to the distributed amplifier, a signal that includes at least a signal component of equal to or less than a high-frequency-side cutoff frequency of the distributed amplifier in an input signal input to the first demultiplexer itself and outputs, to an RF amplifier as an output destination of the first demultiplexer itself, a signal that includes at least a signal component of equal to or greater than a low-frequency-side cutoff frequency of the RF amplifier as the output destination of the first demultiplexer itself in the input signal input to the first demultiplexer itself, a second demultiplexer that is different from the first demultiplexer from among the plurality of disposed demultiplexers outputs, to a demultiplexer in a subsequent stage, a signal that includes at least a signal component of equal to or less than the high-frequency-side cutoff frequency of the distributed amplifier in the input signal input to the second demultiplexer itself and outputs, to an RF amplifier as an output destination of the second demultiplexer itself that is different from the output destination of the demultiplexer in the subsequent stage, a signal that includes at least a signal component of equal to or greater than a low-frequency-side cutoff frequency of the RF amplifier as the output destination of the second demultiplexer itself in the input signal input to the second demultiplexer itself, a first multiplexer from among the plurality of disposed multiplexers multiplexes an output signal of an RF amplifier that adopts, as a signal input source, a demultiplexer to which the distributed amplifier is connected with an output signal of the distributed amplifier, and a second multiplexer that is different from the first multiplexer from among the plurality of disposed multiplexers multiplexes an output signal of a multiplexer in a previous stage with an output signal of an RF amplifier that adopts, as a signal input source, a demultiplexer in a further previous stage with respect to a demultiplexer to which the RF amplifier outputting a signal to the multiplexer in the previous stage is connected.

(Supplement 8) A baseband amplifier according to the present invention includes: a distributed amplifier; and an RF amplifier that has a higher frequency transmission characteristic than the distributed amplifier and has an input terminal connected to an input terminal of the distributed amplifier and an output terminal connected to an output terminal of the distributed amplifier, in the distributed amplifier, an input/output impedance outside a band of the distributed amplifier is a high impedance, and in the RF amplifier, an input/output impedance outside a band of the RF amplifier is a high impedance.

### Industrial Applicability

The present invention can be applied to a technique that realizes a broadband amplifier.

### Reference Signs List

3, 4 Unit cell
5 Serial-parallel circuit
6, 13, 13-1, 13-2 Multiplexer
10 Distributed amplifier
11, 11-1, 11-2 RF amplifier
12, 12-1, 12-2 Demultiplexer
120, 120a to 120c, 130, 130a to 130c Directional coupler
121 to 123, 131 to 133, CPW1, CPW1a, CPW1b, CPW2, CPW2a,
CPW2b, CPW10, CPW20, CPW30 to CPW32, CPW40 to CPW47 Transmission line
Q30, Q31, Q40, Q41 Transistor
R1 to R4, R30 to R32, R40, R41 Resistor
C30, C31, C40 to C46 Capacitor

## Claims

1. A baseband amplifier comprising:
a distributed amplifier;
an RF amplifier configured to have a higher frequency transmission characteristic than the distributed amplifier;
a demultiplexer configured to output, to the distributed amplifier, a signal that includes at least a signal component of equal to or less than a high-frequency-side cutoff frequency of the distributed amplifier in an input signal and output, to the RF amplifier, a signal that includes at least a signal component of equal to or greater than a low-frequency-side cutoff frequency of the RF amplifier in the input signal; and
a multiplexer configured to multiplex a signal amplified by the distributed amplifier and a signal amplified by the RF amplifier.

2. The baseband amplifier according to claim 1,
wherein each of the demultiplexer and the multiplexer includes a directional coupler,
the directional coupler configuring the demultiplexer has an input port connected to an input terminal of the baseband amplifier, a transmitted port connected to an input terminal of the distributed amplifier, and a coupled port connected to an input terminal of the RF amplifier, and
the directional coupler configuring the multiplexer has an input port connected to an output terminal of the distributed amplifier, a transmitted port connected to an output terminal of the baseband amplifier, and a coupled port connected to an output terminal of the RF amplifier.

3. The baseband amplifier according to claim 1,
wherein a gain of the RF amplifier is higher than a gain of the distributed amplifier, and
a difference between a gain in a band of the RF amplifier and a gain in a band of the distributed amplifier is equal to a sum of coupling losses occurring in the demultiplexer and the multiplexer.

4. The baseband amplifier according to claim 1,
wherein in the distributed amplifier, a high-frequency-side gain is higher than a low-frequency-side gain in a band of the distributed amplifier, and
in the RF amplifier, a low-frequency-side gain is higher than a high-frequency-side gain in a band of the RF amplifier.

5. The baseband amplifier according to claim 1,
wherein each of the demultiplexer and the multiplexer includes a directional coupler,
the directional coupler configuring the demultiplexer has an input port connected to an input terminal of the baseband amplifier, a transmitted port connected to an input terminal of the distributed amplifier, and an isolated port connected to an input terminal of the RF amplifier, and
the directional coupler configuring the multiplexer has an input port connected to an output terminal of the distributed amplifier, a transmitted port connected to an output terminal of the baseband amplifier, and an isolated port connected to an output terminal of the RF amplifier.

6. The baseband amplifier according to claim 1,
wherein each of the demultiplexer and the multiplexer includes a directional coupler,
the directional coupler configuring the demultiplexer includes
a first transmission line disposed between an input port and a transmitted port,
a second transmission line configured to be electromagnetically coupled to the first transmission line,
a third transmission line having one end connected to an end portion on a side opposite to a coupled port or an isolated port out of two end portions of the second transmission line, and
a first termination resistor having one end connected to the other end of the third transmission line and the other end connected to ground, and
the directional coupler configuring the multiplexer includes
a fourth transmission line disposed between an input port and a transmitted port,
a fifth transmission line configured to be electromagnetically coupled to the fourth transmission line,
a sixth transmission line having one end connected to an end portion on a side opposite to a coupled port or an isolated port out of two end portions of the fifth transmission line, and
a second termination resistor having one end connected to the other end of the sixth transmission line and the other end connected to the ground.

7. The baseband amplifier according to claim 1,
wherein a plurality of the RF amplifiers are disposed to be aligned in parallel with the distributed amplifier,
a plurality of the demultiplexers are disposed to be aligned in series, the number of the demultiplexers being the same as the number of the RF amplifiers,
a plurality of the multiplexers are disposed to be aligned in series, the number of the multiplexers being the same as the number of the RF amplifiers,
the plurality of disposed RF amplifiers have mutually different frequency transmission characteristics,
a first demultiplexer from among the plurality of disposed demultiplexers outputs, to the distributed amplifier, a signal that includes at least a signal component of equal to or less than a high-frequency-side cutoff frequency of the distributed amplifier in an input signal input to the first demultiplexer itself and outputs, to an RF amplifier as an output destination of the first demultiplexer itself, a signal that includes at least a signal component of equal to or greater than a low-frequency-side cutoff frequency of the RF amplifier as the output destination of the first demultiplexer itself in the input signal input to the first demultiplexer itself,
a second demultiplexer that is different from the first demultiplexer from among the plurality of disposed demultiplexers outputs, to a demultiplexer in a subsequent stage, a signal that includes at least a signal component of equal to or less than the high-frequency-side cutoff frequency of the distributed amplifier in the input signal input to the second demultiplexer itself and outputs, to an RF amplifier as an output destination of the second demultiplexer itself that is different from the output destination of the demultiplexer in the subsequent stage, a signal that includes at least a signal component of equal to or greater than a low-frequency-side cutoff frequency of the RF amplifier as the output destination of the second demultiplexer itself in the input signal input to the second demultiplexer itself,
a first multiplexer from among the plurality of disposed multiplexers multiplexes an output signal of an RF amplifier that adopts, as a signal input source, a demultiplexer to which the distributed amplifier is connected with an output signal of the distributed amplifier, and
a second multiplexer that is different from the first multiplexer from among the plurality of disposed multiplexers multiplexes an output signal of a multiplexer in a previous stage with an output signal of an RF amplifier that adopts, as a signal input source, a demultiplexer in a further previous stage with respect to a demultiplexer to which the RF amplifier outputting a signal to the multiplexer in the previous stage is connected.

8. A baseband amplifier comprising:
a distributed amplifier; and
an RF amplifier that has a higher frequency transmission characteristic than the distributed amplifier and has an input terminal connected to an input terminal of the distributed amplifier and an output terminal connected to an output terminal of the distributed amplifier,
wherein in the distributed amplifier, an input/output impedance outside a band of the distributed amplifier is a high impedance, and
in the RF amplifier, an input/output impedance outside a band of the RF amplifier is a high impedance.
